# EUROPÄISCHE PATENTSCHRIFT

(11) **EP 0 353 443 B1**
(45) Veröffentlichungstag und Bekanntmachung des Hinweises auf die Patenterteilung: **27.01.1993**
(21) Anmeldenummer: 89111345.8
(22) Anmeldetag: 22.06.1989
(51) Int. Cl.: H05K 5/00

(54) **Gehäuse für ein elektronisches Gerät**
Case for an electronic apparatus
Boîtier pour un appareil électronique

(30) Priorität: 03.08.1988 DE 3826382
(43) Veröffentlichungstag der Anmeldung: 07.02.1990
(73) Patentinhaber: Mannesmann Kienzle GmbH (HR B1220), 78052 Villingen-Schwenningen (DE)
(72) Erfinder: Hautvast, Heinz-Josef, D-7734 Brigachtal (DE); Kelch, Heinz, D-7744 Königsfeld 5 (DE); Koch, Siegfried, D-7730 Villingen-Schwenningen (DE)

(56) Entgegenhaltungen:
- EP-A- 0 133 301
- DE-U- 8 306 171
- US-A- 3 904 812
- US-A- 4 587 593

## Beschreibung

Die Erfindung betrifft ein Gehäuse für ein elektronisches Gerät, welches als eine an einer Wand anflanschbare Raumzelle sowohl verschmutzungs- und eingriffssicher verschließbar, als auch stufenweise ausbaufähig ausgebildet ist, wenigstens einen Rahmen, eine Deckel, einen Boden, innerhalb des Rahmens ausgebildete Mittel zur Aufnahme einer Leiterplatte und durch Boden und Deckelhindurchgreifende Schrauben aufweist. Ein solches Gehäuse ist aus EP-A-0 133 301 bekannt.

Für die meisten Informations- und Regelaufgaben sowie die hierfür erforderlichen Datenerfassungs- und Datenverarbeitungsvorgänge, bei denen beispielsweise mehrere Meßgrößen oder Grenzwerte zu einer einzigen Aussage verknüpft oder mit organisatorischen Daten verglichen oder verrechnet werden, ist in der Regel die Rechen- und Verarbeitungskapazität sog. Einplatinenrechner völlig ausreichend.

Sind, wie beispielsweise bei Nutzfahrzeugen, eine Vielzahl solcher Aufgaben gegeben, so ist es wegen der Austausch- und Wartungsfähigkeit sowie wegen der Wahlmöglichkeit der Käufer und der anwendungsspezifischen Anpaßfähigkeit des betreffenden Datenverarbeitungssystems zweckmäßig, daß für jede Aufgabe bzw. für jedes Aufgabengebiet oder bestimmte Aufgabengruppen ein Rechnermodul zusätzlich zu einem Basismodul vorgesehen wird, um eine möglichst hohe Effizienz im Fahrzeugbetrieb zu erzielen. Solche Aufgabengebiete sind im Zusammenhang mit einem Nutzfahrzeug beispielsweise die Arbeitszeiterfassung und die rechtzeitige und richtliniengemäße Information des bzw. der Fahrer des Fahrzeuges, die Datenermittlung für eine Optimierung des Fahrzeugeinsatzes, die Verarbeitung und Anzeige aktueller Betriebsdaten, z. B. auch die akustische Signalgabe bei unzulässigen Betriebszuständen des Fahrzeuges, die Erfassung und Aufbereitung bestimmter Betriebsdaten für eine rechtzeitige und flexible, d. h. den Erfordernissen angepaßte Fahrzeugwartung, die Tourenführung und Auftragserfassung bei der Warenverteilung und/oder Warenübernahme oder die Erfassung des Benutzungsgrades und der Auslastung öffentlicher Verkehrsmittel sowie unterschiedlichste Kontroll- und Steuerfunktionen bei Spezialfahrzeugen, beispielsweise bei Kühlfahrzeugen, Streufahrzeugen und dergl.

Verständlicherweise ergeben sich im Gegensatz zu einer stationären Anwendung in einem Fahrzeug schon aufgrund der unterschiedlichen Fahrzeugarchitekturen und aufgrund des rauhen Einsatzmilieus erhebliche Einbauprobleme für derartige Rechnermodule. Ferner werden im allgemeinen hohe Ansprüche an die Servicefreundlichkeit gestellt und somit eine gute Zugänglichkeit und Austauschfähigkeit erwartet. Dabei scheidet, wenn aus der Vielzahl der denkbaren Rechnermodule nur wenige ausgewählt werden, auch wegen des eng begrenzten Raumangebotes, eine flächige Anordnung der Module nebeneinander oder gar eine "verstreute" Anordnung aus. Außerdem erfordern die anwendungsspezifische Anpaßbarkeit und die Wahlmöglichkeit des Käufers, daß das jeweilige Datenverarbeitungssystem nicht nur von Automobilherstellern einbaubar ist, sondern in jeder Kundendienstwerkstatt nachgerüstet oder erstmals sozusagen vor Ort "zugeschnitten" werden kann, und zwar um die Kosten für ein derartiges System so niedrig wie möglich zu halten, mit einem möglichst geringen Bauteilebedarf und einem Minimum an Verkabelungs- und Montageaufwand.

Die für die vorgesehene Anpaßbarkeit erforderliche hohe Modularität erfordert die Lagerhaltung und Bereitstellung der Bauteile des Systems in einer großen Anzahl, d. h. die Bauteile müssen großserienfertigungsfähig sein und somit möglichst einfach gestaltet sein, so daß sie mit möglichst wenigen und einfachen Werkzeugen gut reproduzierbar hergestellt werden können.

Die Aufgabe der vorliegenden Erfindung bestand somit darin, eine Gehäusearchitektur zu finden, mit welcher ein sowohl den Bedingungen der Großserienfertigung gerecht werdendes, insbesondere preisgünstig herstell- und montierbares, als auch für den Einsatz in einem Fahrzeug geeignetes und auf einfache Weise erweiterbares Gehäuse für ein elektronisches Gerät, mit anderen Worten für eine zentrale Anordnung eines oder mehrerer Rechnermodule, gebildet werden kann.

Die Lösung dieser Aufgabe ist gekennzeichnet durch einen, an einer Stirnseite des Rahmens ausgebildeten, umlaufenden Steg, eine an der anderen Stirnseite des Rahmens ausgebildete, umlaufende Nut,durch wenigstens eine an einer Wand des Rahmens vorgesehene Öffnung, über welche ein Steckersockel zugänglich ist, durch einen Boden, an welchem deckungsgleich zum Rahmen an einer Seite ein Steg, an der anderen Seites eine Nut ausgebildet sind und durch einen dem Boden gleichgestalteten Deckel.

Zweckmäßige Weiterbildungen der Erfindung beschreiben die Unteransprüche.

Das erfindungsgemäße Gehäusekonzept sieht somit einen fertigungstechnisch besonders einfach herstellbaren Rahmen sowie einen Boden und einen Deckel, die identisch ausgebildet sind, vor. Bei geeigneter Ausbildung der Nut-Steg-Verbindungen kann hiermit bereits eine selbsttragende Raumzelle gebildet werden. Dieser Rahmen, in den die Leiterplatte des jeweiligen Rechnermoduls vor der Gehäusekomplettierung eingesetzt werden kann- die Leiterplatte bleibt also vor der Montage des Gehäuses beidseitig zugänglich und prüffähig - läßt sich als Baugruppe an Lager legen und mit oder ohne Deckel als stabilisierende Zwischenplatte verschmutzungs- und eingriffssicher zu einem mehrlagigen Gehäuse stapeln. Dabei sind lediglich längere Schrauben erforderlich, um einen aus mehreren Rahmen gebildeten Modulblock zusammenzuhalten.

Besonders vorteilhaft ist ferner eine Ausführungsform, wobei in der einen Rahmenwand lediglich eine grob tolerierte Öffnung vorgesehen ist, durch die hindurch die Steckverbindungen mit dem bzw. den auf der Leiterplatte angeordneten Steckersockeln vorgenommen werden können. Diese Öffnung wird mittels einer mit Befestigungsmitteln für die zu- und abgehenden Kabel versehenen Installationshaube verschlossen, welche in den Rahmen einrenkbar ausgebildet ist und welche in vorteilhafter Weise durch Setzen einer Schraube des Gehäuses festgehalten wird.

Somit sind für die Herstellung des eigentlichen den oder die Rechnermodule tragenden Gehäuses und für die Bauteile der Erweiterungen lediglich drei Werkzeuge erforderlich.

Das Befestigen des Gehäuses beispielsweise an einer Chassiswand kann im einfachsten Falle dadurch erfolgen, daß die durch das Gehäuse hindurchgeführten Schrauben mit der Chassiswand verschraubt werden. In diesem Falle sind lediglich vier Schrauben erforderlich, um das Gehäuse bzw. den Modulblock zusammenzuhalten und an einer Chassiswand zu befestigen. Vorteilhafter ist es jedoch, dem Gehäuse Befestigungsbügel zuzuordnen, mit denen die Gehäuseschrauben verbindbar sind und die ihrerseits an einer Chassiswand verschraubt werden. Dadurch lassen sich Verspannungen des Gehäuses bei unebener Unterlage weitgehend vermeiden und ein Öffnen des Gehäuses bzw. ein Aufstocken kann, wenn zwischen den Bügeln und dem Gehäuseboden eine geeignete kraftschlüssige Verbindung vorgesehen wird, bei an der Chassiswand montiertem Boden vorgenommen werden. Diese Befestigung des Gehäuses gestattet eine einigermaßen gefällige äußere Form, d. h. auf andernfalls erforderliche an Böden bzw. Deckeln angeformte Befestigungsösen kann verzichtet werden.

Der Vollständigkeit halber sei noch erwähnt, daß ein Ausbau beispielsweise auch mit Leiterplatten, die nur den halben Rahmen ausfüllen, vorgesehen werden kann und daß die Leiterplatten mit Steckverbindungen versehen sind, um einen internen Leitungsbus zwischen mehreren Leiterplatten zu installieren.

Entscheidend ist, daß mit der gefundenen Lösung die Vorleistungen für das erweiterungsfähige Basismodul eines Datenverarbeitungssystems relativ gering sind.

Im folgenden sei die Erfindung anhand der beigefügten Zeichnungen näher erläutert. Es zeigen
FIGUR 1 eine perspektivische Übersichtsdarstellung des erfindungsgemäßen Gehäuses,
FIGUR 2 eine Draufsicht des Gehäuses mit einem Teilschnitt von Deckel und Haube,
FIGUR 3 einen Schnitt des teilweise dargestellten und um eine zweite Ausbaustufe erweiterten Gehäuses,
FIGUR 4 eine teilweise dargestellte Seitenansicht des Gehäuses gemäß FIGUR 3 mit einer in Montagestellung befindlichen Haube,
FIGUR 5 eine Teildarstellung des Gehäuses gemäß FIGUR 1 mit eine boden bzw. wandbündige Befestigung gestattenden Befestigungsmitteln.

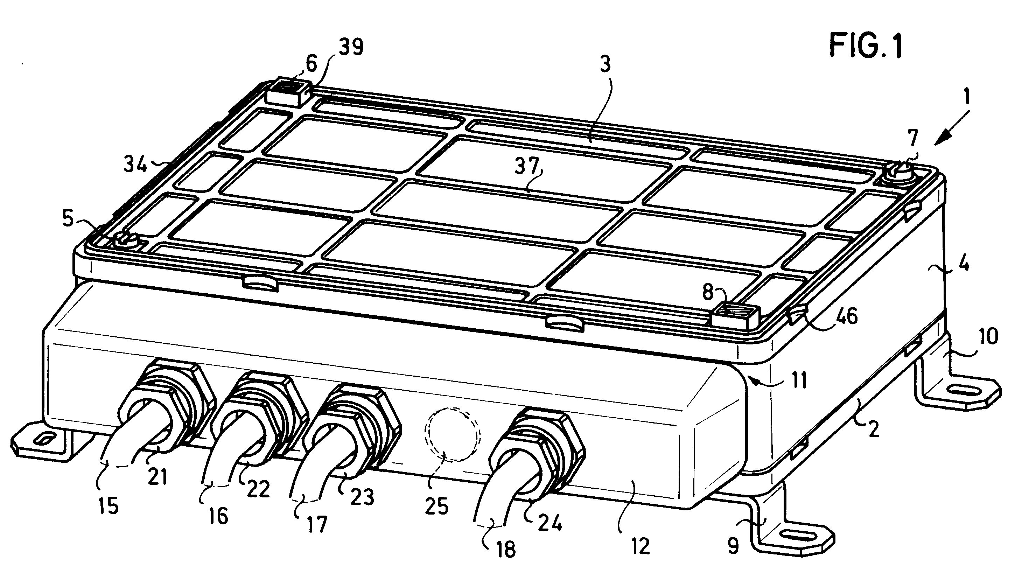

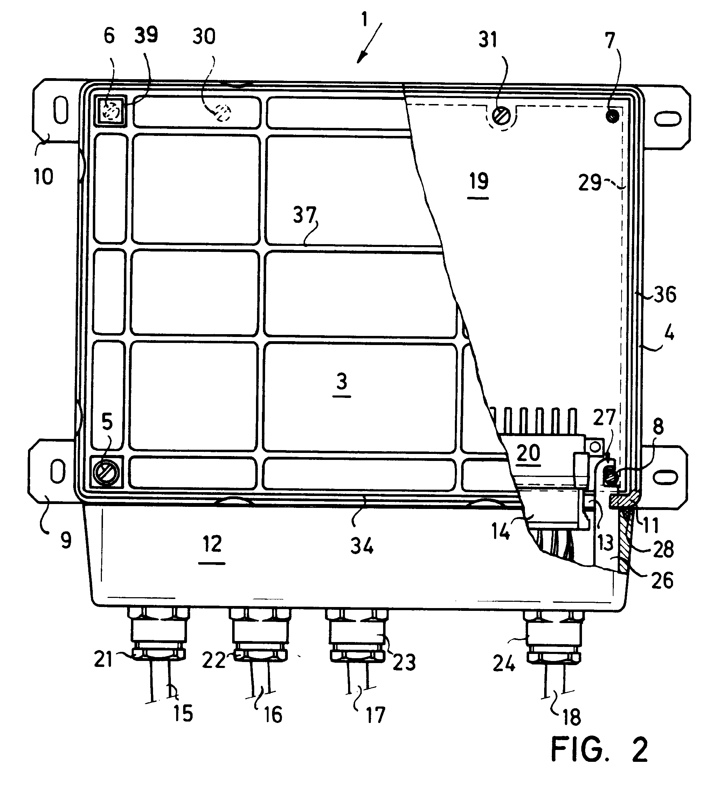

Wie FIGUR 1 zeigt, besteht das Gehäuse 1 im wesentlichen aus einem Boden 2, einem Deckel 3 und einem Rahmen 4, die zusammengefügt und mittels Schrauben 5, 6, 7 und 8, von denen zwei - 6 und 8 - verplombt sind, mit der Befestigung des Gehäuses 1 an einer Chassiswand dienenden Bügeln 9 und 10 verschraubt sind. Eine einer Wand 11 des Rahmens 4 zugeordnete Haube 12 dient der Abdeckung wenigstens einer Öffnung 13 (FIGUR 2) in der Wand 11, durch welche Stecker, z. B. 14, die die zugeführten elektrischen aber auch lichtleitenden Kabel, beispielsweise 15, 16, 17 und 18, abschließen, in das Innere des Rahmens 4 einführbar und mit auf einer Leiterplatte 19 befestigten Steckersockeln, von denen ein in FIGUR 2 dargestellter mit 20 bezeichnet ist, verbindbar sind. Die zugentlastende Befestigung der Kabel 15, 16, 17 und 18 an der Haube 12 erfolgt mittels an sich üblicher Quetschverbinder 21, 22, 23 und 24. Nicht besetzte, jedoch wahlweise verfügbare Kabeldurchführungen bleiben mit einem bei der Herstellung der Haube 12 ausgebildeten, ausbrechbaren Angußfilm 25 verschlossen. Die Kabel stellen die Verbindungen zu Sensoren, zu anderen Geräten, die beispielsweise bereits verdichtete Daten liefern, zu Einrichtungen, die gesteuert oder geregelt werden sollen, zu Handeingabegeräten, zu Anzeige oder Druckaggregaten, zu transportablen Speichern und dergl. her.

Die Haube 12 ist ferner derart ausgebildet, daß sie mittels einer eine Einsteck- und Verschiebebewegung erfordernden Renkverbindung an der Wand 11 des Rahmens 4 gehaltert wird. Zur Sicherung der Renkverbindung und Befestigung der Haube 12 an der Wand 11 des Gehäuses 1 dient ein an der Haube 12 ausgebildeter Haken 26, der eine Aussparung 27 aufweist. Im eingerenkten Zustand der Haube 12 befindet sich die Aussparung 27 im Einsteckweg der Schraube 8, d. h. nach dem Setzen und Plombieren der Schraube 8 ist gleichzeitig auch die Haube 12, der eine umlaufende Dichtung 28 zugeordnet ist, gesichert.

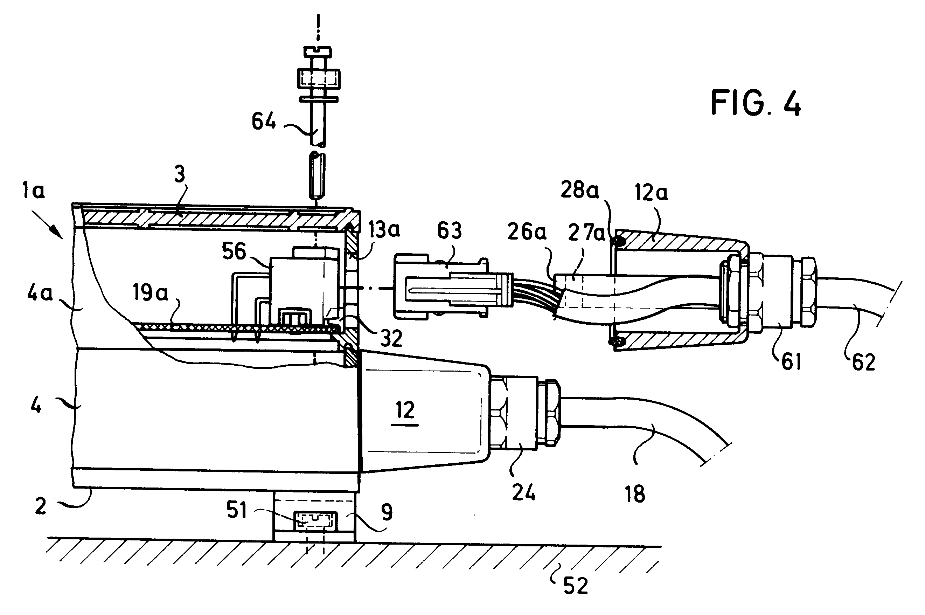

Wie aus FIGUR 2 ferner noch ersichtlich ist, ist innerhalb des Rahmens 4 eine der Leiterplatte 19 als Auflage dienende, umlaufende Leiste 29, die beispielsweise auch in einzelne Konsolen aufgeteilt sein kann, ausgebildet. Gehalten wird die Leiterplatte 19, die außer den Steckverbindern für die verschiedenen Ein- und Ausgänge die Bauelemente des Rechners trägt, von zwei mit geeigneten, nicht näher beschriebenen Vorsprüngen der Leiste 29 verbindbaren Schrauben 30 und 31 sowie einer an der Gegenseite des Rahmens 4 ausgebildeten Schlitzverbindung, welche durch beispielsweise zwei der Leiste 29 zugeordnete und mit einem gewissen Abstand nebeneinander angeordnete Nasen 32 (FIGUR 4) verwirklicht ist.

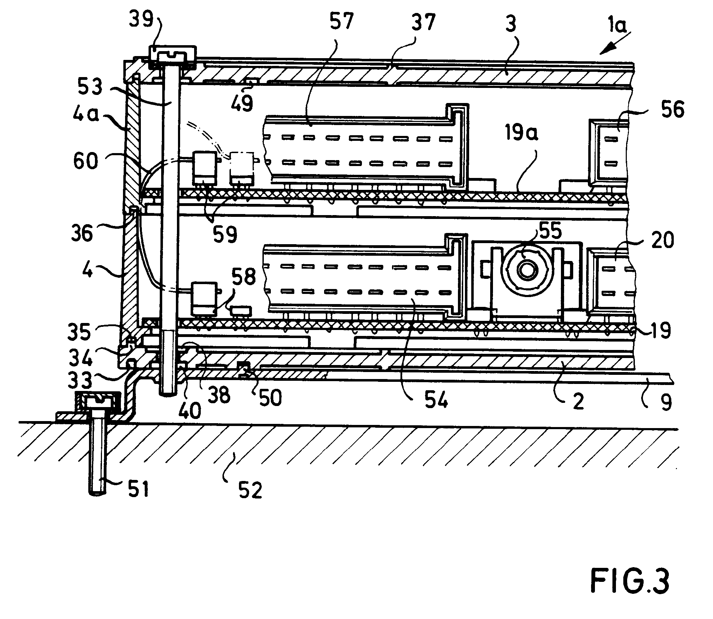

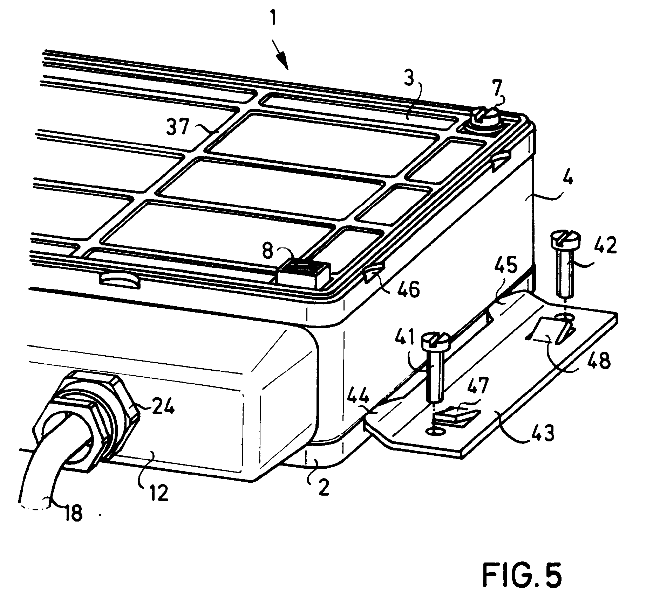

Um eine verschmutzungs- und eingriffssichere Raumzelle zu schaffen, sind an dem Boden 2, dem Deckel 3 und dem Rahmen 4 einander zugeordnet jeweils eine umlaufende Nut 33 bzw. 35 und ein umlaufender Steg 34 bzw. 36 ausgebildet, so daß bereits beim Zusammenfügen der drei Bauteile eine selbsttragende Nut-Feder- bzw. -Stegverbindung entsteht, die, falls erforderlich, zusätzlich durch geeignetes Dichtmaterial ausgefugt sein kann. Dabei sind, wie insbesondere im Schnitt gemäß FIGUR 3 ersichtlich, Boden 2 und Deckel 3 völlig gleichgestaltet, d. h. der Boden 2 und der Deckel 3 sind durch beidseitiges Verrippen 37 versteift und der Wärmeabstrahlung wegen oberflächenvergrößert. Außerdem sind die nicht näher bezeichneten Durchgangsbohrungen für die Schrauben 5, 6, 7 und 8 sowohl mit Senkungen 38 für das Anbringen von Plombennäpfchen 39 als auch mit auf den Gegenseiten befindlichen Senkungen 40 für ein verdrehgesichertes Einsetzen und versenktes Anordnungen von den Schrauben 5, 6, 7 und 8 zugeordneten Muttern versehen. Die Verwendung von Muttern ist in den Fällen erforderlich, in denen eine boden-bzw. wandbündige Befestigung des Gehäuses 1 gemäß FIGUR 5 erfolgen soll.

Bei der Befestigungsweise gemäß FIGUR 5 werden wenigstens zwei mittels Schrauben 41 und 42 befestigbare Halteschienen 43 verwendet, an denen Klauen 44 und 45 angeformt sind. Diese greifen in geeignete, aufgrund der Gleichgestaltung in Boden 2 und Deckel 3 ausgebildete Aussparungen - eine ist mit 46 bezeichnet - ein. Aus den Halteschienen 43 herausgebogene Lappen 47 und 48 dienen der Plombensicherung, beispielsweise einem hier nicht dargestellten Plombennäpfchen als Verdrehsicherung.

An Boden 2 und Deckel 3 sind ferner, wie aus FIGUR 3 ersichtlich ist, Senkungen 49 ausgebildet, die der form- und kraftschlüssigen Verbindung mit den Bügeln 9 und 10 bzw. mit dort angeformten Zapfen 50 dienen. Die Bügel 9 und 10 und damit das Gehäuse 1 bzw., wie FIGUR 3 zeigt, ein durch einen zweiten Rahmen 4a erweitertes Gehäuse 1a sind mittels plombierter Schrauben 51 mit beispielsweise einer Chassiswand 52 verschraubt. Die FIGUR 3 zeigt ferner, daß für die Erweiterung des Gehäuses 1 lediglich längere Schrauben 53 bzw. 64 in FIGUR 4, die durch beide Rahmen 4 und 4a und die Leiterplatten 19 und 19a hindurchgreifen, erforderlich sind. Mit 54 und 55 sind weitere der Leiterplatte 19 zugeordnete Steckersockel bezeichnet. 56 und 57 stellen Steckersockel dar, die auf der Leiterplatte 19a befestigt und mit dieser kontaktiert sind. Ferner tragen die Leiterplatten 19 und 19a paarweise Steckersockel 58 und 59, über welche ein Leitungsbus 60, welcher durch eine geeignete Aussparung in der jeweiligen Leiste 29 durchgeschleift ist, von Leiterplatte zu Leiterplatte koppelbar ist.

Aus FIGUR 4 ist ersichtlich, daß dem erweiterten Rahmen 4a ebenfalls eine Haube 12a zugeordnet ist. Ein durch die Quetschverbindung 61 hindurchgreifendes Kabel 62 ist mittels eines Steckers 63 abgeschlossen, welcher mit dem Steckersockel 56 verbindbar ist. In der in FIGUR 4 gezeigten Stellung wird diese Verbindung gerade vorgenommen. Danach wird das Kabel 62 zurückgezogen, um das Kabelstück zwischen dem Stecker 63 und der Haube 12a zu verkürzen, die Haube 12a im Rahmen 4a eingerenkt und durch Setzen der Schraube 64 gesichert und letztlich das Kabel 62 in der Haube 12a mittels der Quetschverbindung 61 verspannt.

Es sei noch erwähnt, daß unterschiedlich große Leiterplatten 19 im Rahmen 4 befestigt werden können, wobei es ausreichend sein kann, lediglich Rastverbindungen zwischen dem Rahmen und der betreffenden Leiterplatte vorzusehen. Es ist somit denkbar, zusätzlich zu einem Basisrechner mit nur einer Gehäuseerweiterung zwei weitere Zusatzrechner zu installieren. Erwähnt sei ferner, daß zur Ableitung von Störspannungen nach Masse wenigstens die Innenseiten des Gehäuses metallisiert bzw. mit einem Leitlack versehen sind und daß die Leiterplatten über die Leisten 29 mit Masse kontaktiert sind.

## Patentansprüche

1. Gehäuse für ein elektronisches Gerät, welches als eine an einer Wand anflanschbare Raumzelle sowohl verschmutzungs- und eingriffssicher verschließbar, als auch stufenweise ausbaufähig ausgebildet ist, wenigstens einen Rahmen (4), einen Deckel (3), einen Boden (2), innerhalb des Rahmens (4) ausgebildete Mittel (29) zur Aufnahme einer Leiterplatte (19), und durch Boden (2) und Deckel (3) hindurchgreifende Schrauben (5, 6, 7, 8) aufweist
gekennzeichnet
durch, einen einer Stirnseite des Rahmens (4) an einerseits ein umlaufender Steg (36), eine an der anderen Stirseite des Rahmens (4) ausgebildete, umlaufende Nut (35)
durch wenigstens eine an einer Wand (11) des Rahmens (4) vorgesehene Öffnung (13), über welche ein Steckersockel (20) zugänglich ist,
durch einen Boden (2), an welchem deckungsgleich zum Rahmen (4) an einer Seites ein Steg (34), an der anderen Seites eine Nut (33) ausgebildet sind, und
durch einen dem Boden (2) gleichgestalteten Deckel (3).

2. Gehäuse nach Anspruch 1,
dadurch gekennzeichnet,
daß mit den Böden/Deckeln (2/3) verbindbare, der Befestigung des Gehäuses (1) an einer Wand (52) dienende Bügel (9, 10) vorgesehen und
daß in den Bügeln (9, 10) den Schrauben (5, 6, 7, 8) zugeordnete Gewinde ausgebildet sind.

3. Gehäuse nach Ansruch 2,
dadurch gekennzeichnet,
daß die Bügel (9, 10) an den Böden/Deckeln (2/3) kraftschlüssig fixierbar sind.

4. Gehäuse nach Anspruch 1,
dadurch gekennzeichnet,
daß zur boden- bzw. wandbündigen Befestigung des Gehäuses (1) an einer Wand (52) wenigstens zwei Halteschienen (43) vorgesehen sind,
daß an den Böden/Deckeln (2/3) stirnseitig Aussparungen (46) ausgebildet sind und
daß an den Halteschienen (43) den Aussparungen (46) zugeordnete Klauen (44, 45) angeformt sind.

5. Gehäuse nach Anspruch 1,
dadurch gekennzeichnet,
daß mit der mit der Öffnung (13) versehenen Wand (11) des Rahmens (4) eine mit Kabeldurchführungs- und Festhaltemitteln (21, 22, 23, 24) ausgestattete Haube (12) derart verbindbar ist, daß die Haube (12) unmittelbar durch eine der Gehäuseschrauben (8) plombierbar ist.

## Claims

1. Housing for an electronic device, which is constructed as a compartment cell, which can be flanged to a wall, can be closed off such that it is protected against soiling and intervention, can be expanded in steps, and has at least a frame (4); a cover (3); a base (2); means (29), constructed within the frame (4), for receiving a printed circuit board (19); and screws (5, 6, 7, 8) penetrating through the base (2) and the cover (3), characterized by a peripheral rib (36) constructed on one end side of the frame (4), a peripheral groove (35) constructed on the other end side of the frame (4), by at least one opening (13) which is provided on a wall (11) of the frame (4) and through which a plug socket (20) is accessible, by a base (2) on which, coincident with the frame (4), a rib (34) is made on one side and a groove (33) is made on the other side, and by a cover (3) of the same construction as the base (2).

2. Housing according to Claim 1, characterized in that there are provided brackets (9, 10) which can be connected to the bases/covers (2/3) and which serve to secure the housing (1) to a wall (52), and in that threads associated with the screws (5, 6, 7, 8) are formed in the brackets (9, 10).

3. Housing according to Claim 2, characterized in that the brackets (9, 10) can be fixed non-positively to the bases/covers (2/3).

4. Housing according to Claim 1, characterized in that at least two holding rails (43) are provided for the floor- or wall-flush securing of the housing (1) to a wall (32), in that cutouts (46) are made on the bases/covers (2/3) on the end side, and in that claws (44, 45) associated with the cutouts (46) are integrally formed on the holding rails (43).

5. Housing according to Claim 1, characterized in that a hood (12) which is equipped with cable entry and holding means (21, 22, 23, 24) can be connected to the wall (11) of the frame (4) which is provided with the opening (13) such that the hood (12) can be lead-sealed directly by one of the housing screws (8).

## Revendications

1. Boîtier pour un appareil électronique lequel, en tant que cellule spatiale pouvant être fixée par bride sur une paroi, est réalisé de manière à pouvoir, d'une part, être fermé pour être protégé contre l'encrassement et des interventions externes et, d'autre part, être graduellement extensible, contient au moins un cadre (4), un couvercle (3), un fond (2), des moyens (29) réalisés à l'intérieur dudit cadre (4) pour recevoir une platine à circuits imprimés (19) et des vis (5, 6, 7, 8) traversant ledit fond (2) et ledit couvercle (3),
caractérisé
par une nervure circonférentielle (36) formée sur l'une des faces frontales dudit cadre (4), une rainure circonférentielle (35) formée sur l'autre face frontale dudit cadre (4), par au moins une ouverture (13) prévue sur l'une des parois (11) dudit cadre (4) par l'intermédiaire de laquelle il est possible d'accéder à un connecteur mâle (20),
par un fond (2) sur lequel sont formées, en coïncidence avec ledit cadre (4), d'un côté une nervure (34) et, de l'autre côté, une rainure (33) et
par un couvercle (3) de configuration identique audit fond (2).

2. Boîtier selon la revendication 1,
caractérisé par le fait
qu'i est prévu des étriers (9, 10) pouvant être assemblés avec lesdits fonds/couvercles (2/3), servant à la fixation dudit boîtier (1) sur une paroi (52) et
que des taraudages associés audites vis (5, 6, 7,8) ont été pratiqués dans lesdits étriers (9, 10).

3. Boîtier selon la revendication 2,
caractérisé par le fait
que lesdits étriers (9, 10) peuvent être fixés par un assemblage par force sur lesdits fonds/couvercles (2/3).

4. Boîtier selon la revendication 1,
caractérisé par le fait
que, pour la fixation dudit boîtier (1) à fleur d'un fond ou d'une paroi sur une paroi (52), il est prévu au moins deux glissières de fixation (43),
que, sur lesdits fonds/couvercles (2/3), sont pratiqués, du côté frontal, des évidements (46) et
que sur lesdites glissières de fixation (43) sont formées des griffes (44, 45) associées auxdits évidements (46).

5. Boîtier selon la revendication 1,
caractérisé par le fait
que la paroi (11) pourvue de l'ouverture (13) dudit cadre (4) peut être assemblée avec un capot (12) équipé de moyens d'arrêt (21, 22, 23, 24) de telle sorte que ledit capot (12) est directement plombable par l'une des vis de boîtier (B).
